# EUROPEAN PATENT APPLICATION

(11) **EP 4 618 146 A1**
(43) Date of publication of application: **17.09.2025**
(21) Application number: 25160574.7
(22) Date of filing: 27.02.2025
(51) Int. Cl.: H01L 23/522, H01L 23/64, H01L 23/66, H01L 23/00, H10D 1/20, H01L 25/065, H01L 25/00

(54) **VERTICAL CIRCUIT DIE WITH LATERAL SIDE METAL**

(30) Priority: 14.03.2024 US 202418605058
(71) Applicant: Avago Technologies International Sales Pte. Limited, Singapore 768923 (SG)
(72) Inventor: Han, Chang Hoon, Santa Clara, CA, 95051 (US)
(74) Representative: Grünecker Patent- und Rechtsanwälte PartG mbB

(57) **Abstract**

A vertically oriented circuit die with lateral side metal can include a substrate and a die disposed on the substrate in a vertical orientation. The die can include a via disposed on a lateral side of the die, a metal line disposed on a bottom side of the die, and an electrical connection positioned in the via for coupling the metal line and the substrate.

## Description

### BACKGROUND

This disclosure relates, in general, to semiconductor and integrated circuit fabrication technologies. More specifically, the disclosure relates to fabrication of different types of circuit dies that can be fabricated and connected to a substrate.

### BRIEF DESCRIPTION OF THE DRAWINGS

FIG. 1 shows a top view of an example circuit including multiple dies connected to a common substrate, in accordance with some aspects of the disclosure.
FIG. 2 shows a perspective view of a die of the circuit of FIG. 1 that is disposed on the substrate in a horizontal orientation, in accordance with some aspects of the disclosure.
FIG. 3 shows a cross section of the die of FIG. 2 that is disposed on the substrate in the horizontal orientation, in accordance with some aspects of the disclosure.
FIG. 4 shows a top view of another example circuit including multiple dies connected to a common substrate, in accordance with some aspects of the disclosure.
FIG. 5 shows a perspective view of a die of the circuit of FIG. 4 that is disposed on the substrate in a vertical orientation, in accordance with some aspects of the disclosure.
FIG. 6 shows an isolated view of the die of FIG. 5, in accordance with some aspects of the disclosure.
FIG. 7 shows a cross section of the die of FIG. 5 that is disposed on the substrate in the vertical orientation, in accordance with some aspects of the disclosure.
FIG. 8 shows an example saw line associated with the fabrication of the die of FIG. 5, in accordance with some aspects of the disclosure.
FIGS. 9A-9H show a variety of data associated with the performance of the die of FIG. 2 and the die of FIG. 5, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

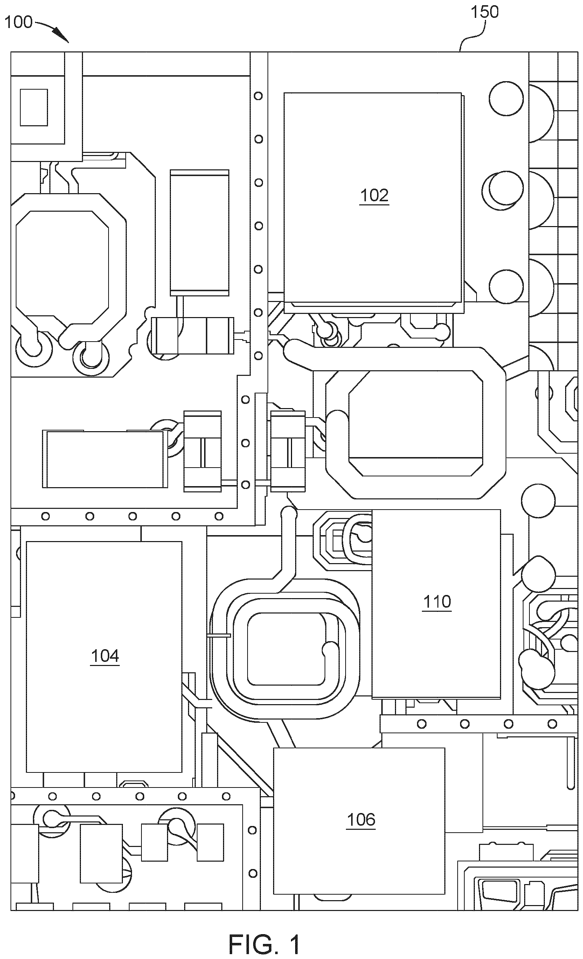

Referring to FIG. 1, a top view illustrating an example circuit 100 including multiple dies connected to a common substrate 150 is shown, in accordance with some aspects of the disclosure. The circuit 100 can be any of a variety of different types of circuits, including various types of integrated circuits used in various types of electronic devices. As shown in FIG. 1, a die 102, a die 104, a die 106, and a die 110 are all connected to a common substrate 150 as part of the circuit 100. The die 102, the die 104, the die 106, and the die 110 can be any of a variety of different types of circuit dies, including filter dies, amplifier dies, and other types of dies. For example, the die 110 can be a radio frequency (RF) filter die, a surface acoustic wave (SAW) filter die, a bulk acoustic wave (BAW) filter die, a power amplifier (PA) die, a low noise amplifier (LNA) die, or another type of circuit die. The die 110 can be fabricated on a wafer of silicon (e.g., electronic-grade silicon (EGS)) or another type of semiconductor wafer (e.g., gallium arsenide (GaAs)) using suitable photolithography processes, for example. The die 110 can include any suitable combination of electronic components that work together to perform an intended function such as, for example, resistors, capacitors, inductors, and/or other electronic components. The die 110 can also be packaged in various ways to protect the die 110 upon connection to the substrate 150. The substrate 150 can be, for example, a printed circuit board (PCB) that can be used in various types of electronic devices.

As shown in FIG. 1, the die 102, the die 104, the die 106, and the die 110 are disposed on the substrate 150 in a horizontal orientation. That is, a width (measured along the x-axis from the top view shown in FIG. 1) and/or a length (measured along the y-axis from the top view shown in FIG. 1) of the die 110, for example, is greater than a height of the die 110 (measured along the z-axis from the top view shown in FIG. 1). This planar assembly of the die 110 such that the die 110 is disposed on the substrate 150 in a horizontal orientation can have drawbacks in some applications. For example, assembling the die 110 in the horizontal orientation typically requires helper (matching) inductors to be drawn in the substrate 150 underneath the die 110. However, in a circuit such as the circuit 100 where there are multiple dies formed on the substrate 150 (i.e., the die 102, the die 104, the die 106, and the die 110), the presence of these helper inductors within the same general plane of the substrate 150 can create unwanted coupling effects at least in part due to their proximity to one or more ground planes in the substrate 150. These coupling effects can cause signal rejection and/or isolation and can negatively affect the performance of the circuit 100 and its various components. Moreover, due to the high Q factor (requirement) of the helper inductors, the helper inductors typically need to occupy significant space within the substrate 150.

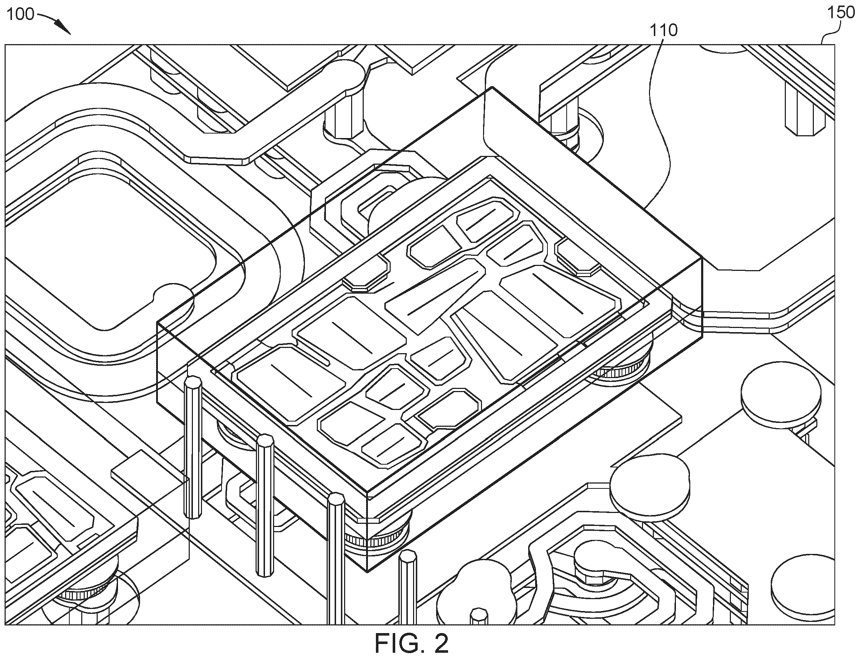

Referring to FIG. 2, a perspective view illustrating the die 110 disposed on the substrate 150 in the horizontal orientation is shown, in accordance with some aspects of the disclosure. The die 110 can be connected to the substrate 150 electrically through one or more vias disposed on a bottom surface (i.e., the surface closest to and parallel with the top surface of the substrate 150). The vias of the die 110 can be provided in various arrangements and can be formed using various suitable materials and combinations thereof depending on the application. For example, the die 110 can include four copper vias disposed generally in the four corners of the die 110. Again, it can be seen from the perspective view shown in FIG. 2 that, in the horizontal orientation, the width (measured along the x-axis from the top view shown in FIG. 1) and/or the length (measured along the y-axis from the top view shown in FIG. 1) of the die 110 is greater than a height of the die 110 (measured along the z-axis from the top view shown in FIG. 1).

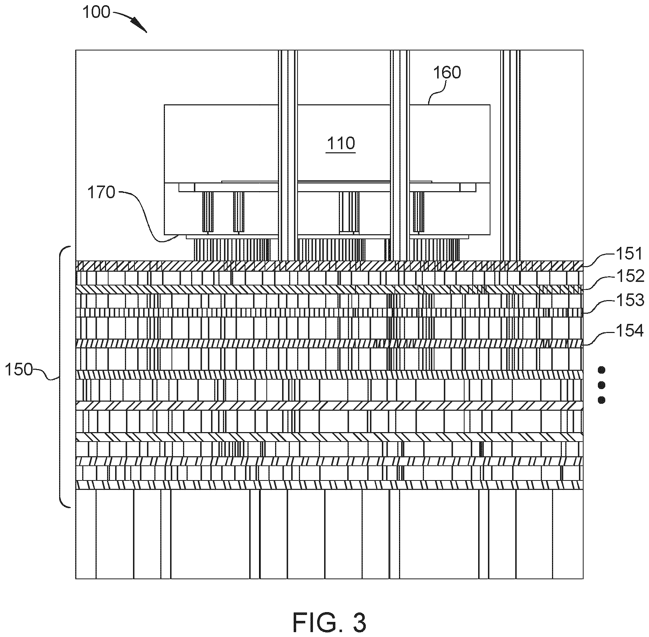

Referring to FIG. 3, a cross section illustrating the die 110 disposed on the substrate 150 in the horizontal orientation is shown, in accordance with some aspects of the disclosure. Again, it can be seen from the cross section shown in FIG. 3 that, in the horizontal orientation, the width (measured along the x-axis from the top view shown in FIG. 1) and/or the length (measured along the y-axis from the top view shown in FIG. 1) of the die 110 is greater than a height of the die 110 (measured along the z-axis from the top view shown in FIG. 1). Additionally, from the cross section shown in FIG. 3, it can be seen that the substrate 150 includes multiple layers. These layers include a top layer 151 as well as a layer 152, a layer 153, and a layer 154. The substrate 150 can include various types of layers including conductive layers (e.g., formed using suitable conductive materials such as, for example, copper and/or other materials), substrate layers (e.g., formed using materials such as fiberglass, etc.), insulating layers (e.g., formed using dielectric materials), soldermask layers, silkscreen layers, and/or other types of layers.

As shown in FIG. 3, the die 110 includes a top side 160 that is furthest from the top layer 151 of the substate 150. The die 110 also includes a bottom side 170 that is opposite the top side 160 and closest to the top layer 151 of the substate 150. Notably, the bottom side 170 does not reside below the top layer 151 of the substrate 150, but rather resides above the top layer 151 of the substrate 150. Since the substrate 150 typically needs to include helper inductors for the die 110 when the die 110 is disposed on the substrate in the horizontal orientation, it can significantly limit the available area (or conductive layers) to form an electrical circuit such as helper inductor circuits if the bottom side 170 resides below the top layer 151 of the substrate 150 to reduce the total height. The top layer 151 can be the top (first) conductive layer of the substrate 150 or another type of layer of the substrate 150 such as noted above.

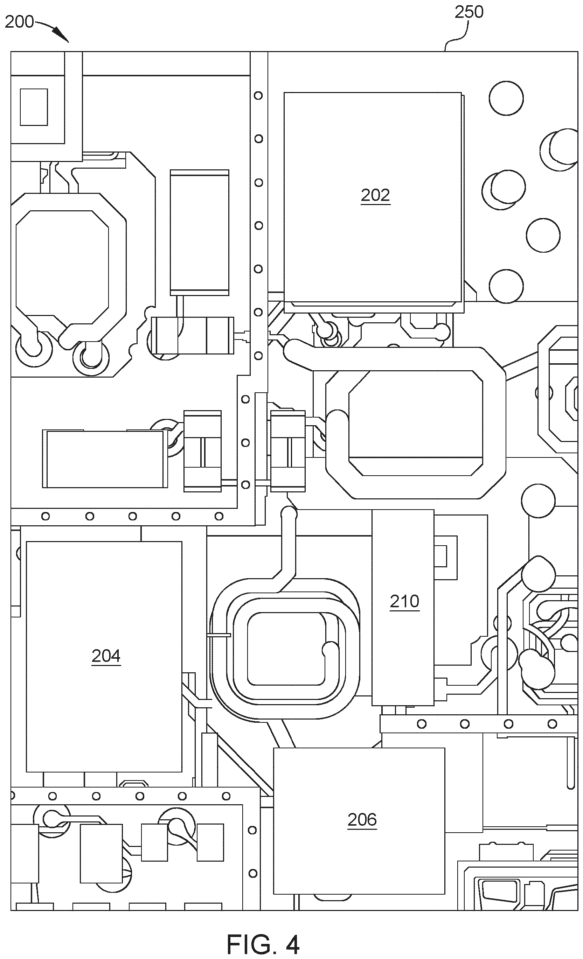

Referring to FIG. 4, a top view illustrating an example circuit 200 including multiple dies connected to a common substrate 250 is shown, in accordance with some aspects of the disclosure. The circuit 200 can be any of a variety of different types of circuits, including various types of integrated circuits used in various types of electronic devices. As shown in FIG. 4, a die 202, a die 204, a die 206, and a die 210 are all connected to a common substrate 250 as part of the circuit 200. The die 202, the die 204, the die 206, and the die 210 can be any of a variety of different types of circuit dies, including filter dies, amplifier dies, and other types of dies. For example, the die 210 can be an RF filter die, a SAW filter die, a BAW filter die, a PA die, an LNA die, or another type of die. That is, various types of circuits can be fabricated on the die 210, including filter circuits and amplifier circuits, among others. The die 210 can be fabricated on a wafer of silicon (e.g., EGS) or another type of semiconductor wafer (e.g., GaAs) using suitable photolithography processes, for example. The die 210 can include any suitable combination of electronic components that work together to perform an intended function such as, for example, resistors, capacitors, inductors, and/or other electronic components. The die 210 can also be packaged in various ways to protect the die 210 upon connection to the substrate 250. The substrate 250 can be, for example, a PCB that can be used in various types of electronic devices.

As shown in FIG. 4, the die 202, the die 204, the die 206, are again disposed on the substrate 250 in a horizontal orientation similar to the die 110 detailed above. However, the die 210 is disposed on the substrate 250 in a vertical orientation rather than in the horizontal orientation. That is, as shown in FIG. 4, the term "vertical orientation" refers to a height of the die 210 (measured along the z-axis from the top view shown in FIG. 4) being greater than at least one of a width (measured along the x-axis from the top view shown in FIG. 4) or a length (measured along the y-axis from the top view shown in FIG. 4) of the die 210. This vertical assembly of the die 210 such that the die 210 is disposed on the substrate 250 in the vertical orientation can provide advantages in various applications.

For example, as will be detailed further below, the helper (matching) inductors for the die 210 can be drawn on the die 210 itself rather than within the substrate 250. As a result, the helper inductors may not experience the same level of Q factor degradation when compared to helper inductors that are drawn within the substrate 250 itself. This effect can be due at least in part to the fact that the helper inductors for the die 210 are not in close proximity to one or more ground planes within the substrate 250, and therefore may not experience the same undesirable coupling effects when compared to helper conductors formed within the substrate 250 itself. Moreover, as can be seen from the top view shown in FIG. 4, by disposing the die 210 on the substrate 250 in the vertical orientation, the occupying area of the die 210 on the substrate 250 can be reduced significantly. For example, compare the occupying area of the die 210 from the top view shown in FIG. 4 to the occupying area of the die 110 from the top view shown in FIG. 1.

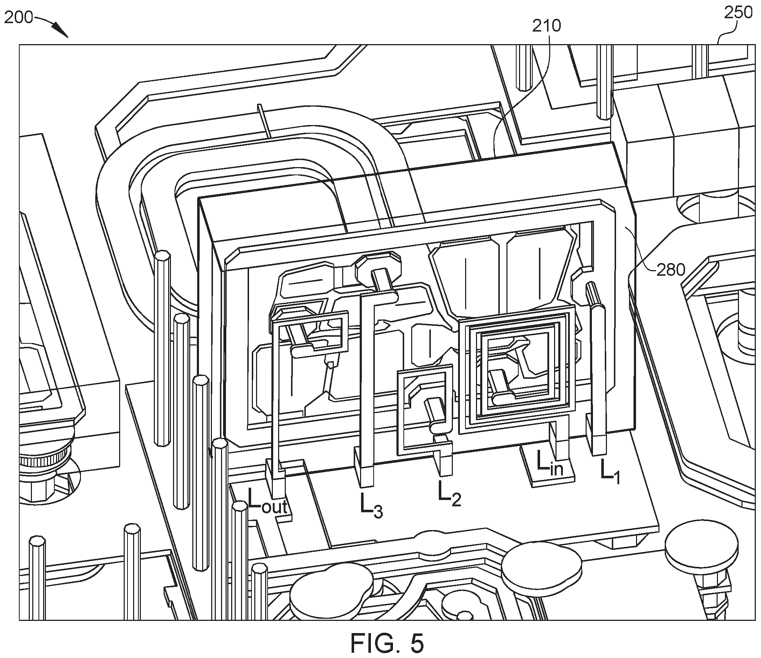

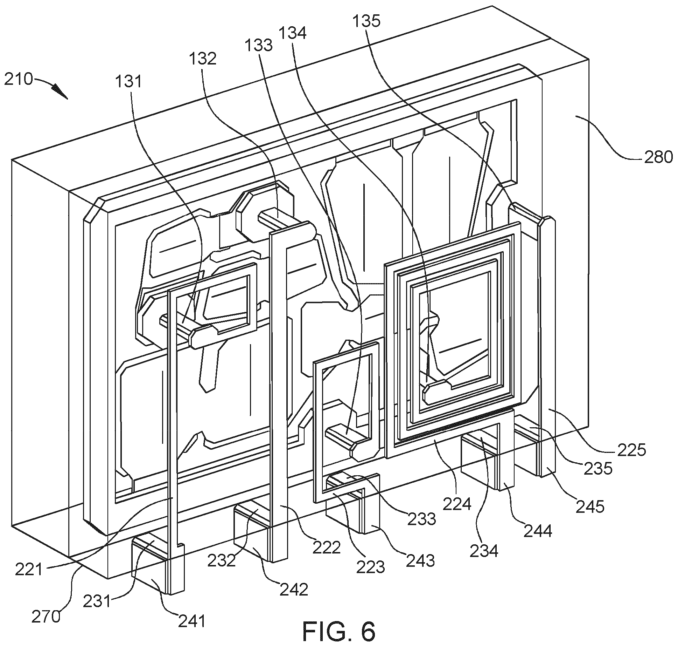

Referring to FIG. 5, a perspective view illustrating the die 210 disposed on the substrate 250 in the vertical orientation is shown, in accordance with some aspects of the disclosure. The die 210 can be connected to the substrate 250 electrically through one or more vias disposed on a bottom surface (i.e., the side closest to and parallel with the top surface of the substrate 250), as will be detailed further below. Again, it can be seen from the perspective view shown in FIG. 2 that, in the vertical orientation, the height of the die 210 (measured along the z-axis from the top view shown in FIG. 4) is greater than at least one of the width (measured along the x-axis from the top view shown in FIG. 4) or the length (measured along the y-axis from the top view shown in FIG. 4) of the die 210. Also, FIG. 5 shows an example implementation of the die 210 where the die 210 includes five metal lines (detailed further below) disposed on a bottom side 280 of the die 210. While the implementation of the die 210 shown in FIG. 5 (and in FIG. 6) includes five metal lines in various configurations, the die 210 can include any suitable number of metal lines drawn on the bottom side 280 depending on the application, and the metal lines can also take various shapes and forms depending on the application. However, the specific implementation of the die 210 as shown in FIG. 5 including five metal lines can be particularly advantageous for high performance of RF filter dies. As shown in FIG. 5, the five metal lines can each be electrically connected to the substate 250 and can each be inductor lines. In the example shown in FIG. 5, two of the inductor lines are shown to be used for input/output signals (Lᵢₙ and Lₒᵤₜ) and three of the inductor lines are shown to be used as helper inductors (L₁, L₂, and L₃).

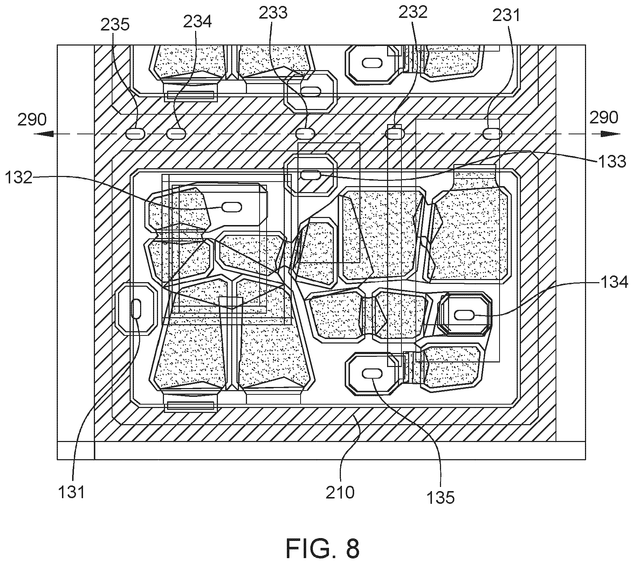

Referring to FIG. 6, a perspective view illustrating the die 210 in the vertical orientation is shown, in accordance with some aspects of the disclosure. As shown, the die 210 includes a first metal line 221 (Lₒᵤₜ) that is disposed on the bottom side 280 of the die 210 and connected to a first via 231. The first via 231 can be disposed on a first lateral side 270 of the die 210 and can generally be formed using side metal as detailed further below with respect to FIG. 8. A first electrical connection can be positioned in the first via 231 for coupling the first metal line 221 and the substrate 250. For example, the first electrical connection can include solder material 241 positioned in the first via 231 as shown. The die 210 is also shown to include a second metal line 222 (L₃) that is disposed on the bottom side 280 of the die 210 and connected to a second via 232. The second via 232 can be disposed on the first lateral side 270 of the die 210 and can generally be formed using side metal. A second electrical connection can be positioned in the second via 232 for coupling the second metal line 222 and the substrate 250. For example, the second electrical connection can include solder material 242 positioned in the second via 232 as shown in FIG. 6.

The die 210 is also shown to include a third metal line 223 (L₂) that is disposed on the bottom side 280 of the die 210 and connected to a third via 233. The third via 233 can be disposed on the first lateral side 270 of the die 210 and can generally be formed using side metal. A third electrical connection can be positioned in the third via 233 for coupling the third metal line 223 and the substrate 250. For example, the third electrical connection can include solder material 243 positioned in the third via 233 as shown in FIG. 6. The die 210 is also shown to include a fourth metal line 224 (Lᵢₙ) that is disposed on the bottom side 280 of the die 210 and connected to a fourth via 234. The fourth via 234 can be disposed on the first lateral side 270 of the die 210 and can generally be formed using side metal. A fourth electrical connection can be positioned in the fourth via 234 for coupling the fourth metal line 224 and the substrate 250. For example, the fourth electrical connection can include solder material 244 positioned in the fourth via 234 as shown in FIG. 6. The die 210 is also shown to include a fifth metal line 225 (L₁) that is disposed on the bottom side 280 of the die 210 and connected to a fifth via 235. The fifth via 235 can be disposed on the first lateral side 270 of the die 210 and can generally be formed using side metal. A fifth electrical connection can be positioned in the fifth via 235 for coupling the fifth metal line 225 and the substrate 250. For example, the fifth electrical connection can include solder material 245 positioned in the fifth via 235 as shown in FIG. 6.

The first metal line 221, the second metal line 222, the third metal line 223, the fourth metal line 224, and the fifth metal line 225 can each be inductor lines as noted. For example, the first metal line 221, the second metal line 222, the third metal line 223, the fourth metal line 224, and the fifth metal line 225 can each include an insulated wire wound into a coil to store energy in a magnetic field when current flows through the wire. However, at least one of the first metal line 221, the second metal line 222, the third metal line 223, the fourth metal line 224, and the fifth metal line 225 can be another type of metal line, such as a conductive line (e.g., formed of copper, another suitable conductive material, or combination of materials). Moreover, as noted, depending on the application, not all of the first metal line 221, the second metal line 222, the third metal line 223, the fourth metal line 224, and the fifth metal line 225 are required (i.e., the die 210 could include alternative quantities of metal lines).

The vias of the die 210 including the first via 231, the second via 232, the third via 233, the fourth via 234, and the fifth via 235 can be implemented in various ways, such as using various different types of copper vias and/or other suitable types of vias. The solder material 241, the solder material 242, the solder material 243, the solder material 244, and the solder material 245 can likewise be implemented in various ways using various suitable types and configurations of solder material. The die 210 can include electrical connections (e.g., the solder material 241, the solder material 242, the solder material 243, the solder material 244, and the solder material 245 in some examples) positioned in the first via 231, the second via 232, the third via 233, the fourth via 234, and the fifth via 235 for coupling the first metal line 221, the second metal line 222, the third metal line 223, the fourth metal line 224, and the fifth metal line 225 to the substrate 250 as noted above. FIG. 6 also shows a collection of vias 131-135 for coupling the first metal line 221, the second metal line 222, the third metal line 223, the fourth metal line 224, and the fifth metal line 225 to a circuit (e.g., a filter circuit, an amplifier circuit, etc.) of the die 210. Vias similar to the vias 131-135 can be used in the horizontally oriented die 110 to couple the die 110 to the substrate 150, for example, as opposed to using the first via 231, the second via 232, the third via 233, the fourth via 234, and the fifth via 235 on the first lateral side 270 of the die 210 to couple the die 210 to the substrate 250.

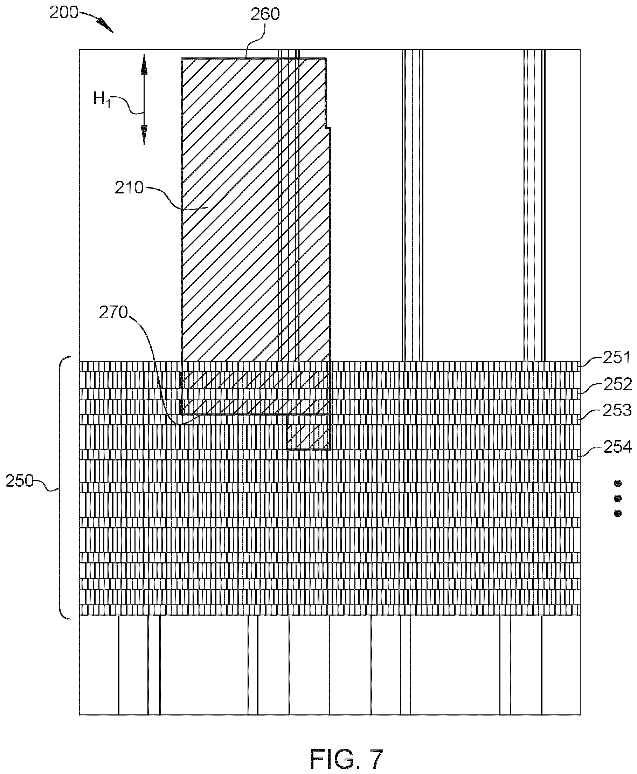

Referring to FIG. 7, a cross section illustrating the die 210 disposed on the substrate 250 in the vertical orientation is shown, in accordance with some aspects of the disclosure. Again, it can be seen from the cross section shown in FIG. 7 that, in the vertical orientation, the height of the die 210 (measured along the z-axis from the top view shown in FIG. 4) is greater than at least one of the width (measured along the x-axis from the top view shown in FIG. 4) or the length (measured along the y-axis from the top view shown in FIG. 4) of the die 210. Additionally, from the cross section shown in FIG. 7, it can be seen that the substrate 250 includes multiple layers. These layers include a top layer 251 as well as a layer 252, a layer 253, and a layer 254. The substrate 250 can include various types of layers including conductive layers (e.g., formed using suitable conductive materials such as, for example, copper and/or other materials), substrate layers (e.g., formed using materials such as fiberglass, etc.), insulating layers (e.g., formed using dielectric materials), soldermask layers, silkscreen layers, and/or other types of layers.

As shown in FIG. 7, the die 210 includes a second lateral side 260 that is opposite the first lateral side 270 and furthest from the top layer 251 of the substate 250. Notably, the first lateral side 270 of the die 210 resides at least partially below the top layer 251 of the substrate 250 as shown. Since the first via 231, the second via 232, the third via 233, the fourth via 234, and the fifth via 235 can be formed on the first lateral side 270 of the die 210 as detailed above, the first lateral side 270 of the die 210 can be made to reside at least partially below the top layer 251 of the substrate 250. In FIG. 7, the first lateral side 270 of the die 210 resides at least partially below the top layer 251 as well as at least partially below the layer 252 and is electrically connected to the layer 253 of the substrate 250 via solder. The top layer 251 can be the top (first) conductive layer of the substrate 250 or another type of layer of the substrate 250 such as noted above. Further, in FIG. 7, a height H₁ is shown. The height H₁ as shown can be the difference in the height of the die 210 (measured along the z-axis from the top view shown in FIG. 4) compared to the height of the die 110 (measured along the z-axis from the top view shown in FIG. 1). In some examples, the height H₁ can be between 150 micrometers (µm) and 175 µm.

Referring to FIG. 8, an example saw line 290 associated with the fabrication of the die 210 is shown, in accordance with some aspects of the disclosure. While the structure of the die 210 including the first via 231, the second via 232, the third via 233, the fourth via 234, and the fifth via 235 disposed on the first lateral side 270 of the die 210 can be advantageous for the reasons detailed above, it can be difficult to form the first via 231, the second via 232, the third via 233, the fourth via 234, and the fifth via 235 on the first lateral side 270 of the 210 using processes such as deposition and etching. However, as shown in FIG. 8, the first via 231, the second via 232, the third via 233, the fourth via 234, and the fifth via 235 can be formed on a wafer at the boundary between adjacent dies such that the saw line 290 extends through the first via 231, the second via 232, the third via 233, the fourth via 234, and the fifth via 235. That is, the first via 231, the second via 232, the third via 233, the fourth via 234, and the fifth via 235 can be formed along the saw line 290 as shown in FIG. 8. As a result, the first via 231, the second via 232, the third via 233, the fourth via 234, and the fifth via 235 can be formed on the first lateral side 270 of the die 210 through the process of cutting (dicing) a wafer by cutting through the wafer on the saw line 290. By using this fabrication technique, the structure of the die 210 as described herein can feasibly be produced. The vias 131-135, which can feasibly be formed using processes such as deposition and etching, can also be seen in FIG. 8.

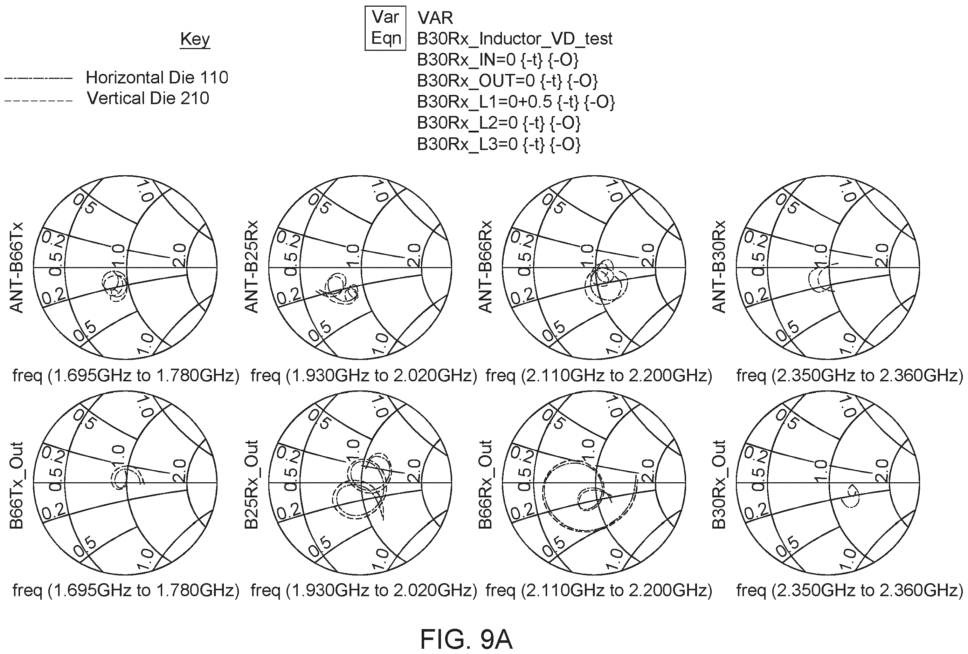

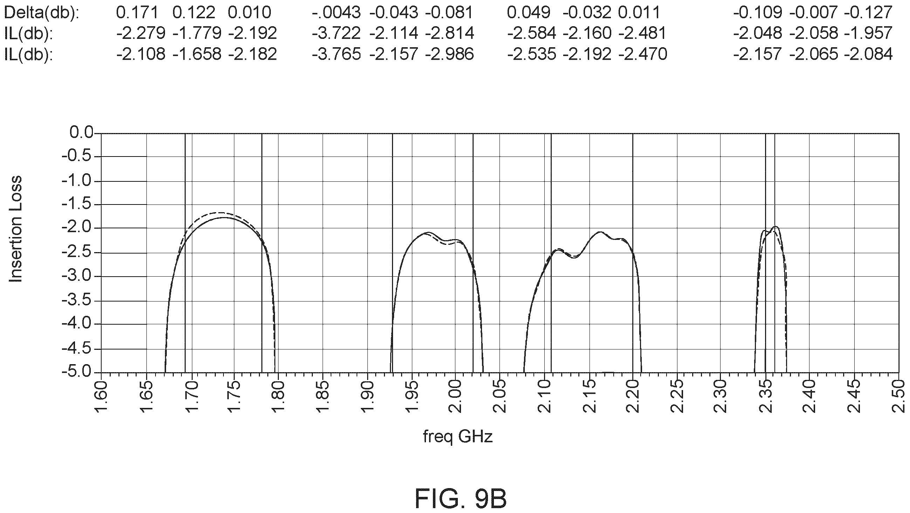

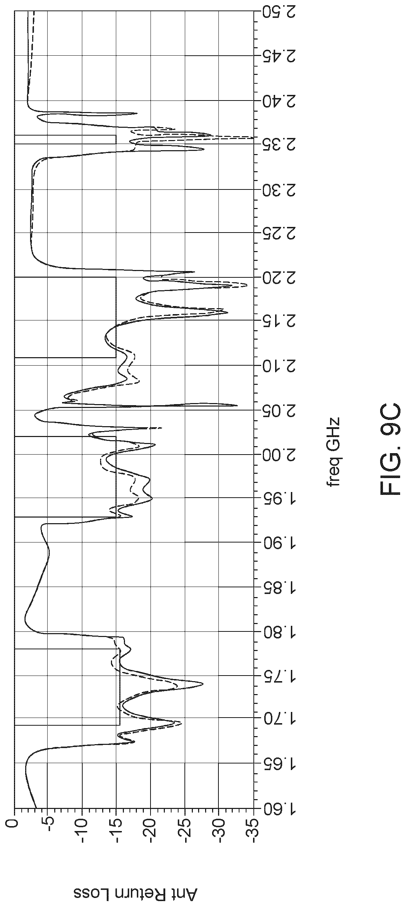

Referring to FIGS. 9A-9H, a variety of experimental data that is associated with the performance of the die 110 and the die 210 is shown, in accordance with some aspects of the disclosure. The data shown in FIGS. 9A-9H is provided as supplementary information to help support the notion of the structure of the vertical die 210 being feasible to produce and satisfactory in performance, and is not intended to be limiting in any way. In particular, the data shown in FIGS. 9A-9H results from simulation of a circuit including one filter die (e.g., the die 210) assembled in a vertical orientation such as detailed above. The data shown in FIGS. 9A-9H can provide insight into the effects of the vertically assembled filter die to the other multiplexing bands' performance as well as the performance of the vertically assembled filter die itself. FIG. 9A specifically shows the frequency response of various types of filter dies oriented horizontally (e.g., the die 110) and vertically (e.g., the die 210). FIG. 9B specifically shows the insertion loss of a horizontally oriented die (e.g., the die 110) and a vertically oriented die (e.g., the die 210). FIG. 9C specifically shows the antenna return loss of a horizontally oriented die (e.g., the die 110) and a vertically oriented die (e.g., the die 210).

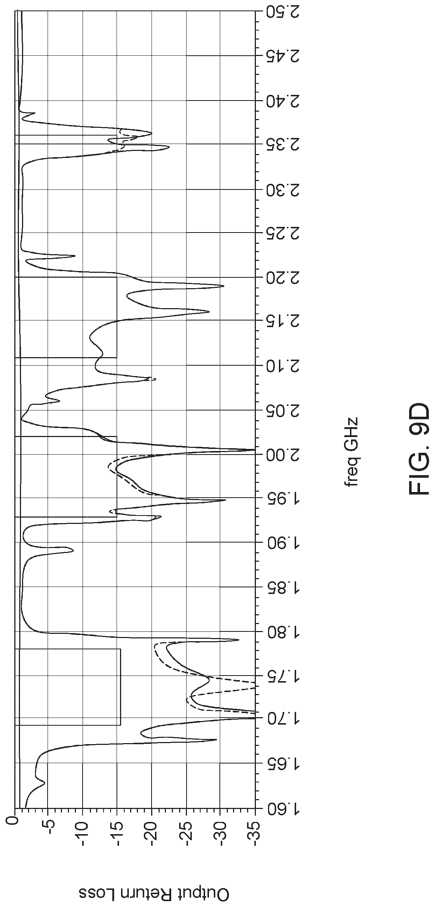

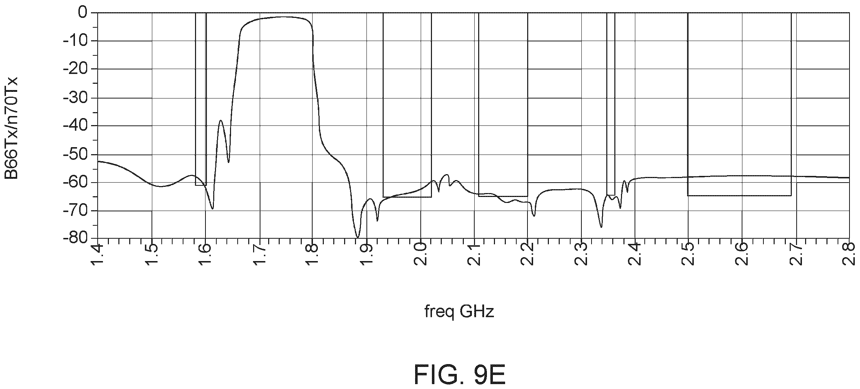

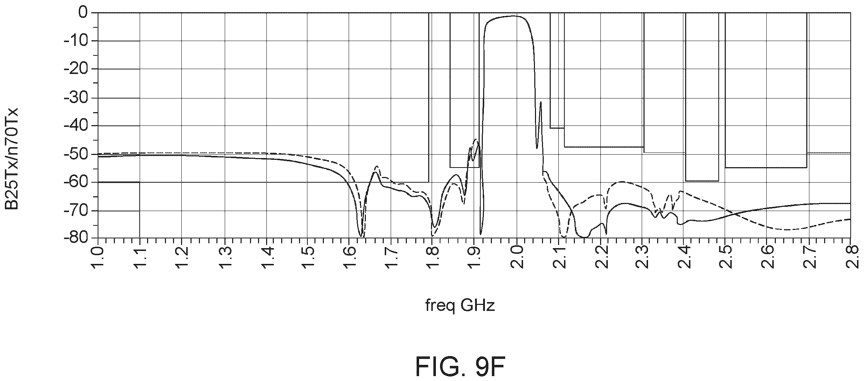

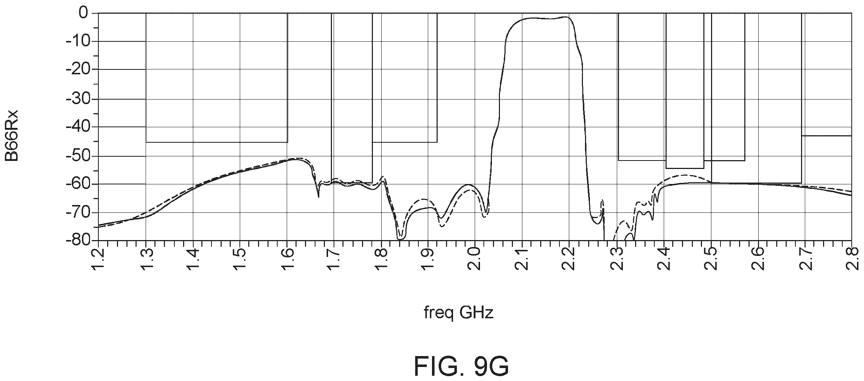

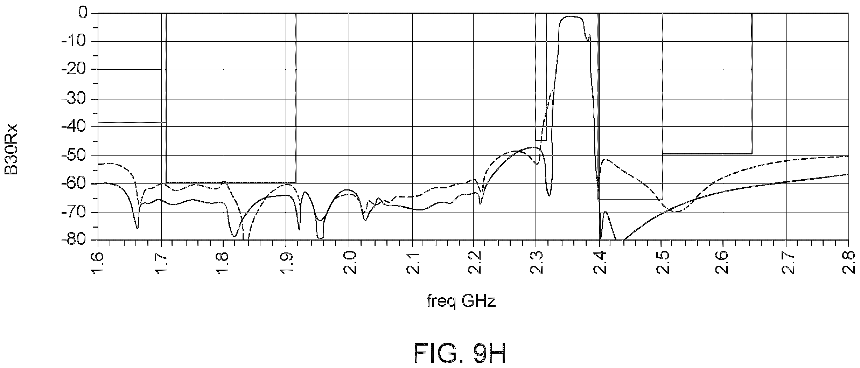

FIG. 9D specifically shows the output return loss of a horizontally oriented die (e.g., the die 110) and a vertically oriented die (e.g., the die 210). FIG. 9E specifically shows the frequency response of two similar specific types of filter dies oriented horizontally (e.g., the die 110) and oriented vertically (e.g., the die 210). FIG. 9F specifically shows the frequency response of two more similar specific types of filter dies oriented horizontally (e.g., the die 110) and oriented vertically (e.g., the die 210). FIG. 9G specifically shows the frequency response of another specific type of filter die oriented horizontally (e.g., the die 110) and oriented vertically (e.g., the die 210). Finally, FIG. 9H specifically shows the frequency response of yet another specific type of filter die oriented horizontally (e.g., the die 110) and oriented vertically (e.g., the die 210). From the data shown in FIGS. 9E-9H in particular, it can be seen that the resulting wideband rejection performance change in each band is acceptable.

## Claims

1. A circuit, comprising:
a substrate; and
a die disposed on the substrate in a vertical orientation, the die comprising:
a via disposed on a lateral side of the die;
a metal line disposed on a bottom side of the die; and
an electrical connection positioned in the via for coupling the metal line and the substrate.

2. The circuit of claim 1, wherein the die is disposed on the substrate such that the lateral side of the die resides below a top layer of the substrate.

3. The circuit of any of the previous claims, comprising:
a second via disposed on the lateral side of the die;
a second metal line disposed on the bottom side of the die; and
a second electrical connection positioned in the second via for coupling the second metal line and the substrate.

4. The circuit of any of the previous claims, wherein the die is disposed on the substrate in the vertical orientation such that a height of the die is greater than a width or a length of the die.

5. The circuit of any of the previous claims, wherein the metal line comprises an inductor line and/or
wherein the die comprises a filter die.

6. A circuit, comprising:
a substrate; and
a die comprising a filter disposed on the substrate in a vertical orientation such that a height of the die is greater than a width or a length of the die, the die comprising:
a via disposed on a lateral side of the die;
a metal line disposed on a bottom side of the die; and
an electrical connection positioned in the via for coupling the metal line and the substrate.

7. The circuit of claim 6, wherein the die is disposed on the substrate such that the lateral side of the die resides below a top layer of the substrate.

8. The circuit of claims 6 or 7, comprising:
a second via disposed on the lateral side of the die;
a second metal line disposed on the bottom side of the die; and
a second electrical connection positioned in the second via for coupling the second metal line and the substrate,
in particular,
wherein the metal line comprises an inductor line and the second metal line comprises a second inductor line.

9. The circuit of any of claims 6 to 8, wherein the filter comprises a radio frequency (RF) filter.

10. The circuit of any of claims 6 to 9, wherein the electrical connection comprises solder material.

11. A die, comprising:
a circuit;
a via disposed on a lateral side of the die;
a metal line disposed on a bottom side of the die; and
an electrical connection positioned in the via for coupling the metal line and a substrate.

12. The die of claim 11, comprising:
a second via disposed on the lateral side of the die;
a second metal line disposed on the bottom side of the die; and
a second electrical connection positioned in the second via for coupling the second metal line and the substrate.

13. The die of claim 11 or 12, wherein the circuit comprises a filter,
in particular,
wherein the filter comprises a radio frequency (RF) filter.

14. The die of any of claims 11 to 13, wherein the circuit comprises an amplifier and/or
wherein the electrical connection comprises solder material and/or
wherein the metal line comprises an inductor line.

15. The die of claim 12, comprising:
a third via disposed on the lateral side of the die;
a third metal line disposed on the bottom side of the die; and
a third electrical connection positioned in the third via for coupling the third metal line and the substrate.
